# EUROPEAN PATENT SPECIFICATION

(11) **EP 2 562 472 B1**
(45) Date of publication and mention of the grant of the patent: **12.12.2018**
(21) Application number: 10850059.6
(22) Date of filing: 23.04.2010
(51) Int. Cl.: H01L 31/055, H01L 31/054, G02B 5/10

(54) **LIGHT CONVERGENCE DEVICE, MANUFACTURING METHOD THEREOF AND SOLAR BATTERY SYSTEM**
LICHTKONZENTRATIONSVERFAHREN, HERSTELLUNGSVERFAHREN DAFÜR UND SOLARZELLENBATTERIESYSTEM
DISPOSITIF DE CONVERGENCE DE LUMIÈRE, SON PROCÉDÉ DE FABRICATION ET SYSTÈME DE PILE SOLAIRE

(43) Date of publication of application: 27.02.2013
(73) Proprietor: Ocean's King Lighting Science & Technology Co., Ltd., Guangdong 518054 (CN)
(72) Inventor: ZHOU, Mingjie, Shenzhen Guangdong 518054 (CN); HUANG, Jie, Shenzhen Guangdong 518054 (CN); WANG, Lei, Shenzhen Guangdong 518054 (CN)
(74) Representative: Johnson, Richard Alan
(86) International application number: PCT/CN2010/072162
(87) International publication number: WO 2011/130925

(56) References cited:
- WO-A2-2006/088369
- CN-A- 1 427 227
- CN-A- 101 187 728
- CN-A- 101 515 607
- JP-A- 2006 078 989
- US-A- 4 227 939
- US-A1- 2004 227 986
- US-A1- 2005 051 205
- US-A1- 2006 039 061
- US-A1- 2008 196 581
- US-A1- 2009 120 488

## Description

### FIELD OF THE INVENTION

The exemplary disclosure relates to solar energy field, and particularly, to a light convergence device, and a manufacturing method for having same, and further relates to a solar battery system with the light convergence device.

### BACKGROUND OF THE INVENTION

Since the beginning of 21st century, global energy issues, environmental pollution and global warming become more and more apparent, and all those problems are gradually intensified. Solar energy has outstanding merits of widespread and broad distribution, rich resources, pollution-free, clean, safe, and being convenient to access, and thus is considered to be one of the most promising renewable energy.

In recent years, one way to use solar energy is to use solar batteries to directly convert solar light into electricity. This is a practical and effective way for using solar energy. The solar batteries have developed for nearly half a century, and photoelectric conversion efficiency of the solar batteries has exceeded 40%. However, production process for producing the solar batteries is complex, and requires highly for equipment and raw materials, resulting in expensive solar battery products. As the price of the solar batteries exceeds acceptable level for customers, use of the solar battery is greatly limited. In another aspect, organic solar batteries have attracted much attention because low price of raw materials, light weight, flexible property, simple production process, and can be manufactured by large area coating, printing, etc. The organic solar batteries can be well developed and applied in the future in fields such as architecture, lighting and power generation industries. However, nowadays, as the photoelectric conversion efficiency of the organic solar batteries is still relatively low, and cannot be practically used, there is still room for improvement of the organic solar batteries.

One way to improve photoelectric conversion efficiency of the solar batteries is to use light convergence devices. The light convergence devices converge solar light incident on a larger area to a solar battery with smaller area, such that optical density of the solar battery surface can be increased, achieving greater light conversion efficiency. However, existing light convergence devices have a lots of problems, thus widespread application of the existing light convergence devices is limited. Take transmission typed spot-focusing light convergence device as an example, the light convergence device must be equipped with a solar tracking device. The tracker is used to keep a light convergence mirror of the light convergence device perpendicular to incident light of the mirror, otherwise output of focused spot from the light convergence device tends to deviate from the solar batteries, resulting in sharp decline of the output power. Take reflection-type light convergence device as another example. The reflection-type light convergence device generally reflects light by a metallic film or a dielectric film on a concave substrate thereof. The metallic film has a relatively wide reflection wave band, and is able to achieve total reflection for lights incident in every angles and having a special wave band. However, reflectivity of the metallic film is relatively low, and energy loss of light wave is relatively high. The dielectric film can only achieve reflection of light with a particular incident angle, and reflection wave band of the dielectric film is quite narrow. In addition, when the solar light is converged to surfaces of the solar batteries by using the light convergence devices, lights with special wave band, such as infrared light may be converted into heat, causing temperature of the solar batteries to increase, and thus the solar batteries is unable to work in best working temperature, resulting in a decline of conversion efficiency.

Furthermore, nowadays most of the solar batteries can only absorb visible lights, and absorb litter lights with other wave bands, such as infrared lights, resulting in relatively low conversion efficiency of the solar batteries. US 4,227,939 and US 2009/0120488 A describe luminescent solar energy concentrator devices. WO 2006/088369 A describes a luminescent object and utilization thereof. US 2005/0051205 describes solar based electrical energy generation with spectral cooling.

In view of the above problems, a light convergence device and a solar battery system with simple structure and high utilization rate of solar energy are provided. In addition, a manufacturing method of the light convergence device, which has simple process and low cost is further provided.

### DISCLOSURE OF THE INVENTION

In accordance with one aspect of the disclosure, a light convergence device is disclosed in claim 1. The light convergence device includes a light convergence substrate. The light convergence substrate includes a rotating paraboloid, wherein a photonic crystal layer is formed on the rotating paraboloid, and an up-conversion layer is formed on the photonic crystal layer, the up-conversion layer comprises an up-conversion material with up-conversion function for spectrum.

In accordance with another aspect of the disclosure, a solar battery system is disclosed in claim 10. The solar battery system uses the light convergence device and a solar battery device. The solar battery device is arranged at an imaginary light convergence flat plane light where light is converged by the rotating paraboloid of the light convergence device.

A method for manufacturing the light convergence device is also disclosed in claim 7. The method includes:
providing a light convergence substrate, the light convergence substrate comprising a rotating paraboloid;
forming a photonic crystal layer on the rotating paraboloid;
forming an up-conversion layer on the photonic crystal layer, wherein the up-conversion layer comprises an up-conversion material with up-conversion function for spectrum.

In said light convergence device and solar battery system, in one aspect, taking advantage of the up-conversion function of the up-conversion material in the up-conversion layer, the light that cannot be fully absorbed by solar batteries or long-wave radiation can be converted into short-wave radiation. For example, near-infrared photons with low-energy can be converted into photons having higher energy, such that absorption and utilization of sunlight by light convergence device can be increased. In another aspect, there is a photonic crystal layer between the up-conversion layer and substrate; the photonic crystal layer is used to reflect light with special frequency, or to totally reflect visible light. The layered structure is simple (without any other additional complex structure). In the manufacturing method, the light convergence device is made by preset steps to form each layer of the device, the processing step is simple and cost efficient, thus has broad application prospects.

### BRIEF DESCRIPTION OF THE DRAWINGS

The accompanying drawings facilitate an understanding of the various embodiments of this invention. In such drawings:
FIG. 1 is a schematic diagram of a light convergence device according to an embodiment.
FIG. 2 is a schematic diagram of a solar battery system using the light convergence device of FIG. 1.
FIG. 3 is a flow chart of a method for manufacturing the light convergence device of FIG. 1.

### DETAILED DESCRIPTION OF ILLUSTRATED EMBODIMENTS

Further description of the present invention will be illustrated, which combined with embodiments in the drawings, in order to make the purpose, the technical solution and the advantages clearer. While the present invention has been described with reference to particular embodiments, it will be understood that the embodiments are illustrative and that the invention scope is not so limited.

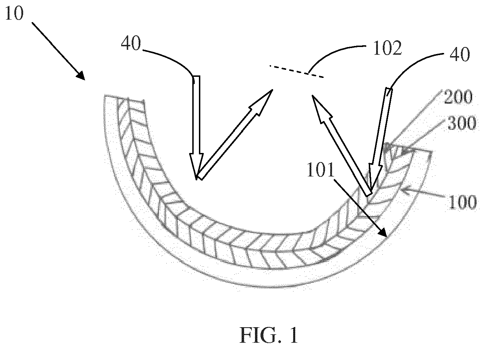

FIG. 1 illustrates structure of a light convergence device 10 in an embodiment of the present disclosure. The light convergence device 10 in this embodiment includes a light convergence substrate 100. The light convergence substrate 100 includes a rotating paraboloid 101. A photonic crystal layer 300 is formed on the rotating paraboloid 101. An up-conversion layer 200 is further formed on the photonic crystal layer 300. The up-conversion layer 200 includes an up-conversion material having up up-conversion function for spectrum.

As shown in FIG. 1, the light convergence substrate 100 is a substrate with uniform thickness. The thickness of the light convergence substrate 100 is preferably about 1 to 20 mm. In alternative embodiments, the light convergence substrate 100 includes a rotating paraboloid 101 (facing the sun) at one side, and a flat surface at the other side. That is, the surface of the substrate 100 facing away from the sun is not limited to curved surface, and can be selected according to actual needs.

The light convergence substrate 100 can be made of glass, organic glass, plastic, ceramic, or metal. In this embodiment, the light convergence substrate 100 is preferably made of material with good reflective properties. The glass can be but not limited to silicate glass, high silica glass, soda lime glass or quartz glass, etc. The organic glass can be but not limited to polymethyl methacrylate (PMMA). The plastics can be but not limited to polyethylene, polypropylene, polycarbonate, polyester or PVC. The ceramic can be but not limited to alumina ceramic or zirconia ceramic. The metal can be but not limited to aluminum or copper, or metallic material with aluminum coated thereon. As the paraboloid 101 has light reflective property, incident light on light convergence substrate 100 can be reflected by the rotating paraboloid 101, and then converged to a smaller flat plane 102.

The photonic crystal layer 300 is located between the up-conversion layer 200 and the light convergence substrate 100. The photonic crystal layer 300 can be preferably a thin film with uniform thickness. The thickness of the photonic crystal layer 300 is about 100nm to 2000nm. FIG. 1 shows the photonic crystal layer 300 and the up-conversion layer 200 each are concave along the rotating paraboloid 101, respectively. That is, the photonic crystal layer 300 and the up-conversion layer 200 are rotating paraboloid-shaped, and are suitable to reflect light and converge light on a smaller light convergence flat plane 102 (relative to the paraboloid 101). The photonic crystal layer 300 can be applied on the rotating paraboloid 101 by vacuum ion plating, magnetron sputtering, vacuum evaporation, chemical vapor deposition, sol-gel method, self-assembly method, deposition method, coating, plastering, painting, nano-imprint lithography (NIL), or other methods.

The photonic crystal layer 300 can be one-dimensional, two-dimensional or three-dimensional. The material of the photonic crystal layer 300 can be, for example, inorganic material, metal dielectric material, organic small molecule and polymer material, or other materials. The inorganic materials can be but not limited to, such as SiO₂, ZnO, SnO₂, NiO, MoO₃, V₂O₅, WO₃ or TiO₂. The metal dielectric material can be but is not limited to GaAs, of AlGaAs, etc., The small organic molecule can be but is not limited to in-pyrazoline, thiophene thiophene, and other materials, The high polymer material can be but is not limited to styrene latex particles or polymer latex particles and silicone rubber with hard-core-soft-shell structure, or methyl methacrylate, etc.

The photonic crystal layer 300 is used to reflect solar light. The reflected light can be but is not limited to visible light with special frequency. In alternative embodiments, the photonic crystal layer 300 can be used to totally reflect visible light. A photonic crystal has a dielectric structure with refractive property, and has corresponding photonic band gap. The width of the band gap is determined by material and structure of the photonic crystal. The present disclosure uses a photonic band gap with at least a whole visible range, for example, a photonic band gap between 300 and 800 nm. The light with frequency in the band gap cannot be transmitted in the photonic crystal, and tends to be reflected. Thus, the photonic crystal layer 300 can be used to reflect light. By selecting crystal material with suitable reflective index and suitable structure, and by controlling width of the band gap of the photonic crystal, reflection or total reflection of the light in a special wavelength range and total visible light waveband can be achieved. For example, in order to design a photonic crystal with wavelength between ultraviolet light to visible light, following design can be processed: a refractive index of the SiO₂ is n1, thickness is d1, and refractive index of the TiO₂ is n2, the thickness is d2, center of band gap wavelength is λ, the two materials (SiO₂ and TiO₂) meet condition n1 d1 + n2 d2 = λ / 2. The photonic crystal between one-dimensional ultraviolet light to visible light for making center of the band gap with wavelength λ = 400 nm can be SiO₂ and TiO₂, with thickness thereof between 10nm to 96 nm. In this manner, one-dimensional photonic crystal with band gap thereof between 7.9 nm to 758.4 nm (that is, between wavelength range between ultraviolet light to visible light) is obtained. Required band gap of other materials can be obtained in a similar manner. The photonic crystal layer 300 thus can be used to reflect or totally reflect light with a special wavelength range and a wavelength range of total visible light.

In this embodiment, preferably, the up-conversion layer 200 can be a layer consisting of organic material and up-conversion material dispersed in the organic material, or composite structure with oxidation film encapsulating on the up-conversion material. In alternative embodiments, the up-conversion layer 200 may be up-conversion material forming directly on the photonic crystal layer 300. The up-conversion material can be granular, and the average particle size of the up-conversion material is about 80nm to 1000nm. Thickness of the up-conversion layer 200 is preferably about 0.1 microns to 20 microns.

The organic material dispersed in the up-conversion layer 200 can be a matrix of small organic molecules, such as three-ethylhexyl phosphoric acid, sodium lauryl sulfate, etc., or a polymer organic matrix, such as silicone rubber, polyethylene, polymethyl methacrylate or polyurethane etc. The oxidation film for encapsulating the up-conversion layer 200 can be ZnO: Al, SnO₂: Sb. Such that a uniform and stable up-conversion layer 200 having film and composite structure can be formed. The up-conversion material can be used stably and persistently.

The up-conversion material of the up-conversion layer 200 can be selected from a group consisting of halides, oxides, or sulfides mixed with singly doped rare-earth ions or co-doped rare-earth ions, or combination thereof. In this embodiment, the oxide can be rare earth oxide, zinc oxide, zirconium oxide or composite oxide. The sulfide can be rare earth sulfide. The up-conversion material is selected from a group consisting of BaY₂F₈, KZnF₃, NaYF₄, NaYb(WO₄)₂, Ga₂S₃-La₂O₃, CaS, Cs₃Lu₂Br₉, Y₂O₃, Gd₂O₃, ZrO₂, ZnO, BaTiO₃, and ZnO-SiO₂ mixed with singly doped or co-doped rare-earth ions. The singly doped or co-doped rare-earth ions are selected from a group consisting of Er³⁺, Ho³⁺, Tm³⁺, Pr³⁺, Yb³⁺/Ho³⁺, Yb³⁺/Tm³⁺, Yb³⁺/Pr³⁺, Yb³⁺/Er³⁺, and Tb³⁺/Er³⁺. In this embodiment, total doping molar ratio of the rare earth ions is not limited. In alternative embodiments, total doping molar ratio of the rare earth ions comparing to the matrix (Halides, oxides, sulfides, or their composition) can be but is not limited to be about 5% to 60%.

In the co-doped rare-earth ions, such as the Yb³⁺/Ho³⁺, Yb³⁺/Tm³⁺, Yb³⁺/Pr³⁺, Yb³⁺/Er³⁺, or Tb³⁺/Er³⁺, the mixed molar ratio of the two ions is 1:0.1 to 1:1. Preferably, the mixed molar ratio of the two ions is 1:0.3 to 1:0.5.

The up-conversion layer 200 has "spectrum regulation and control" function. In operation, the up-conversion layer 200 can be used to converse low-energy light, such as infrared light, photons of near-infrared bands, photons of far-infrared bands, or photons of other wavelengths that cannot be fully absorbed by solar batteries into photons that can be fully absorbed by solar batteries. Long-wave radiation in natural lights can be converted into short-wave radiation. For example, near-infrared photons with low-energy can be converted into photons having higher energy, such as visible light, such that absorption and utilization of sunlight can be increased, and photoelectric conversion performance can be improved. The up-conversion layer 200 can be used in actual application, such as solar battery systems. By selecting proper up-conversion material, long wavelength solar light can be converted into short-wavelength solar light, which is in the bands having maximum absorption property. The solar light thus can be fully absorbed, and photoelectric conversion efficiency of the solar battery system can be improved, accordingly.

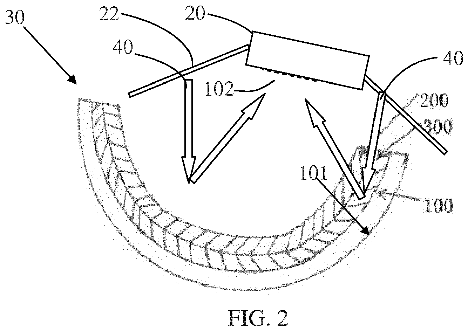

Refer to FIG. 2, a solar battery system 30 using the light convergence device 10 in the above embodiments is disclosed. The solar battery system 30 includes the light convergence device 10 and a solar battery device 20. The light convergence device 10 is disclosed in the above embodiments.

The solar battery device 20 can be solar batteries, such as a variety of crystalline silicon solar batteries, semiconductor solar batteries using inorganic salts, such as gallium arsenide III-V compounds, cadmium sulfide, copper indium selenide and other diverse compounds as basic material, thin film solar batteries or organic solar batteries. As shown in FIG. 2, the solar battery device 20 is arranged in an imaginary light convergence plane 102, at which light is converged by the rotating paraboloid 101. The solar battery device 20 generally has a photoactive layer. In assembly, the photoactive layer is arranged in the light convergence plane 102 to align with the rotating paraboloid 101 to fully absorb the converged light. In this embodiment, for example, the solar battery device 20 can be supported on the edge of the light convergence device 10 (or the light convergence substrate 100) by a bracket 22.

The light convergence device 10 is mainly used to integrate several functions such as wavelength up-conversion function of the up-conversion material, reflection function of the photonic crystal, light convergence function of the paraboloid. As shown in FIG. 2, the solar light 40 is first incident on the up-conversion layer 200. Light of long wavelength in the solar light 40 is absorbed and converted in to light of short wavelength by the up-conversion layer 200. Then the up-conversion layer 200 emits light of short wavelength to the surface of the photonic crystal layer 300. The rest of light which is not absorbed by the up-conversion layer 200 transmits through the up-conversion layer 200 to the surface of the photonic crystal layer 300. The light on the surface of the photonic crystal layer 300 is reflected by the photonic crystal of the photonic crystal layer 300, and further converged by the rotating paraboloid 101 to the light convergence plane 102. In this manner, intensity of the converged light is much greater than that of the light before converged. Furthermore, solar energy is absorbed by the solar battery device 20 arranged at the light convergence plane 102. As optical density on the surface of the solar battery device 20 increases, conversion efficiency of the solar battery device 20 is accordingly increased. In addition, by selecting proper up-conversion material, infrared wave bands in the solar light can be converted into absorbance range wave bands which are rather suitable to be absorbed by the optical active layer, such that light conversion efficiency of the optical active layer in the solar battery device 20 is increased. In such manner adverse effects of the infrared wave bands in the solar light 40 toward performance of the solar battery can be avoided.

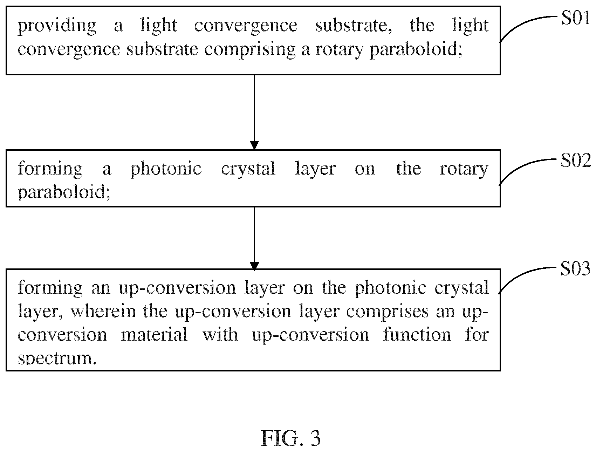

As shown in FIG. 3, a method for manufacturing the light convergence device in this embodiment is also disclosed. The method includes:
S01: Selecting a light convergence substrate, the light convergence substrate including a rotating paraboloid;
S02: forming a photonic crystal layer on the rotating paraboloid;
S03: forming an up-conversion layer on the photonic crystal layer, wherein the up-conversion layer includes an up-conversion material having up-conversion function for spectrum.

In the above steps, the structure and materials of the each layer are correspondingly described above. Referring to FIG. 1 again, the above light convergence device 10 is made by firstly, for example, selecting a light convergence substrate 100 with uniform thickness, such as a glass substrate, etc. In step S01, preferably, the light convergence substrate 100 can be pre-processed. Preferably, the light convergence substrate 100 can be cleaned and then dried. In addition, the rotating paraboloid 101 can be polished or coated with aluminum, etc.

In step S02, the photonic crystal layer 300 can be processed by using vacuum ion plating method, ultra-high vacuum electron beam evaporation, magnetron sputtering, vacuum evaporation, chemical vapor deposition, sol - gel method, self-assembly method, natural deposition, coating, painting, spraying, nano-embossing, etc. The photonic crystal layer 300 is formed on the rotating paraboloid 101, and then dried. The processing method is selected according to material of the photonic crystal layer 300. For example, if the photonic crystal layer 300 is made of inorganic materials, metals and dielectric materials, then vacuum ion plating method, ultra-high vacuum electron beam evaporation, magnetron sputtering, vacuum evaporation, chemical vapor deposition, sol - gel method, self-assembly method, natural deposition, coating, painting, spraying, or other methods can be used. If the photonic crystal layer 300 is made of organic small molecule material, then methods such as sputtering or coating can be used. In alternative embodiments, if the photonic crystal layer 300 is made of high polymer materials, then sol - gel method, coating, plastering, painting, self-assembly method, nano-imprint method can be used. In this embodiment, the photonic crystal layer 300 is formed with thickness of 100nm to 2000nm.

In step S02, the up-conversion layer 200 can be applied on the surface of the photonic crystal layer 300 by vacuum ion plating method, vacuum magnetron sputtering, vacuum evaporation, chemical vapor deposition, sol - gel method, coating, painting, spraying, etc. In this embodiment, the up-conversion layer 200 has two structural manners. In one manner, the up-conversion layer 200 is in the form of being dispersing in the organic material. Accordingly, the up-conversion layer 200 can be formed by the following steps: source compounds of each element in the up-conversion layer 200 serving as raw material, nano- up-conversion material of the up-conversion material is formed by applying a sol - gel method. The nano-particles of the up-conversion material are dispersed in the organic material. When the nano-particles of the up-conversion material are mixed uniformly in the organic material, the organic material with the nano-particles mixed therein is coated on the surface of the photonic crystal layer 300. The organic material is cured to form a film for 10 to 30 hours in the 40 to 80°C temperature environment, thus the up-conversion layer 200 with desired thickness is obtained.

In another manner, the up-conversion layer 200 may be formed by coating an oxidation film on the up-conversion material to thus forming on the surface of the photonic crystal layer 300. For example, by using chemical homogeneous coprecipitation method to coat a ZnO : Al on the surface of the single-doped or co-dope ionic halides, oxides, sulfides, or their composition, and other materials, a transparent up-conversion layer 200 can be formed.

Structure and manufacturing method of the light convergence device 10 are disclosed in the following embodiments.

### Example 1

The light convergence device 10 in this embodiment is shown in FIG. 1. The light convergence substrate 10 is made from a piece of concave glass having a rotary parabolic surface 101. The photonic crystal layer 300 is made of polymer latex particles having hard core - soft-shell structure, and particle size of the polymer latex particles is about 500 nm. Thickness of the photonic crystal layer 300 is about 1000 nm. The up-conversion material of the up-conversion layer 200 is made of Cs₃Lu₂Br₉: Er³⁺. Thickness of the up-conversion layer 200 is about 0.1 µm.

The light convergence device 10 is manufactured by the following process.
(1) Providing a piece of concave glass to serve as a substrate, and the substrate is cleaned and dried;
(2) A manufacturing method as disclosed in Chinese patent application NO. 200510011219.1 is used to prepare emulsion of monodisperse polymer latex particles having hard-core - soft-shell structure, and having monodisperse index of less than or equal to 0.005, and particle size of about 500 nm. The emulsion is then mixed with water uniformly to form emulsion with 10% concentration. The emulsion is then plastered on the concave glass treated in the step (1). The plastered concave glass is then volatilized for 36 hours to form a photonic crystal layer having thickness of 1000nm. The concave glass is then dried.
(3) Nano-particles (particle size of about 5nm) of Er³⁺: Cs₃Lu₂Br₉ weighted 1g is dispersed in 10g polymethyl methacrylate. The nano-particles are mixed uniformly and coated on the photonic crystal layer prepared by step (2). The nano-particles are then cured to form an up-conversion layer having thickness of 0.1 µm in 10 hours and under 80 °C temperature environment. The up-conversion layer can be used to convert 980nm infrared light into visible light having peak value of 50nm. The photons in such wave band can be absorbed efficiently by organic solar batteries. As the solar light can be reflected and converged by the photonic crystal layer, thus efficiency and lifetime of the solar batteries can be greatly improved.

### Example 2

The light convergence device 10 in this embodiment is shown in FIG. 1. The light convergence substrate 100 is made from a piece of organic glass having a rotary parabolic surface 101. The photonic crystal layer 300 is made of polymer latex particles having hard core - soft-shell structure, and particle size of the polymer latex particles is about 650nm. Thickness of the photonic crystal layer 300 is about 1300 nm. The up-conversion material of the up-conversion layer 200 is made of CaS:Eu³⁺/Sm³⁺. Thickness of the up-conversion layer 200 is about 20 µm.

The light convergence device 10 is manufactured by the following process.
(1) Providing a piece of concave glass to serve as a substrate, and the substrate is cleaned and dried;
(2) A manufacturing method as disclosed in Chinese patent application NO. 200510011219.1 is used to prepare emulsion of monodisperse polymer latex particles having hard-core - soft-shell structure, and having monodisperse index of less than or equal to 0.005, and particle size of about 650nm. The emulsion is then mixed with water uniformly to form emulsion with 30% concentration. The emulsion is then plastered on the concave glass treated in the step (1). The plastered concave glass is then volatilized for 48 hours to form a photonic crystal layer having thickness of 1300nm. The concave glass is then dried.
(3) Nano-particles (particle size of about 10nm) of CaS:Eu³⁺,Sm³⁺ weighted 2g is dispersed in 10g polyurethane. The nano-particles are mixed uniformly and coated on the photonic crystal layer prepared by step (2). The nano-particles are then cured to form an up-conversion layer having thickness of 20µm in 30 hours and under 40 °C temperature environment. The up-conversion layer can be used to convert 800 nm to 1600nm infrared light into visible light having peak value of 625nm. The photons in such wave band can be absorbed efficiently by organic solar batteries. As the solar light can be reflected and converged by the photonic crystal layer, thus efficiency and lifetime of the solar batteries can be greatly improved.

### Example 3

The light convergence device 10 in this embodiment is shown in FIG. 1. The light convergence substrate 100 is made from a piece of concave plastic having a rotary parabolic surface 101. The photonic crystal layer 300 is made of SiO₂ and TiO₂. Thickness of the photonic crystal layer 300 is about 480 nm. The up-conversion material of the up-conversion layer 200 is made of BaY₂F₈:Yb³⁺/Ho³⁺. Thickness of the up-conversion layer 200 is about 10µm.

The light convergence device 40 is manufactured by the following process.
(1) Providing a piece of concave glass to serve as a substrate, and the substrate is cleaned and dried;
(2) An ultra-high vacuum electron beam evaporation method as disclosed in Chinese patent application NO. 200410018081 is used to prepare eight SiO₂ films and eight TiO₂ films alternately. Thickness of each of the SiO₂ film and the TiO₂ film is 30nm, forming a photonic crystal layer having thickness of 480nm. The photonic crystal layer can be used to totally reflect visible light.
(3) Nano-particles (particle size of about 15nm) of BaY₂F₈: Yb³⁺/Er³⁺ weighted 3g is dispersed in 10g polyurethane. The nano-particles are mixed uniformly and plastered on the photonic crystal layer prepared by step (2). The nano-particles are then cured to form an up-conversion layer having thickness of 10µm in 24 hours and under 60 °C temperature environment. The up-conversion layer can be used to convert 950nm -1000nm infrared light into visible light having peak value of 500 to 525nm. The photons in such wave band can be absorbed efficiently by organic solar batteries. As the solar light can be reflected and converged by the photonic crystal layer, thus efficiency and lifetime of the solar batteries can be greatly improved.

### Example 4

The light convergence device 10 in this embodiment is shown in FIG. 1. The light convergence substrate 100 is made from a piece of concave ceramic having a rotary parabolic surface 101. The photonic crystal layer 300 is made of silicone and TiO₂. Thickness of the photonic crystal layer 300 is about 5 µm. The up-conversion material of the up-conversion layer 200 is made of ZrF₂-SiO₂: Er³⁺. Thickness of the up-conversion layer 200 is about 15 µm.

The light convergence device is manufactured by the following process.
(1) Providing a piece of concave glass to serve as a substrate, and the substrate is cleaned and dried;
(2) A manufacturing method as disclosed in Chinese patent application NO. 200810018360.9 is used to prepare the photonic crystal layer. In this embodiment, basic material silicone of high polymer is coated on substrate. Monodisperse latex particles having particle size of about 200 nm is mixed in the basic material silicone of polymer by applying nano-imprint, thus the monodisperse latex particles mixed in the basic material silicone of polymer form face-centered cubic structure. A photonic crystal layer having thickness of 5 µm is then formed when it is dried.
(3) Nano-particles (particle size of about 50nm) of ZrF₂-SiO₂: Er³⁺ weighted 1.5g is dispersed in 20g polymethyl methacrylate. The nano-particles are mixed uniformly and sprayed on the photonic crystal layer prepared by step (2). The nano-particles are then cured to form an up-conversion layer having thickness of 15µm in 16 hours and under 50 °C temperature environment. The up-conversion layer can be used to convert 980nm infrared light into visible light having 405nm, 445nm, 525nm, and 548nm wavelength. The photons in such wave band can be absorbed efficiently by organic solar batteries. As the solar light can be reflected and converged by the photonic crystal layer, thus efficiency and lifetime of the solar batteries can be greatly improved.

### Example 5

The light convergence device 10 in this embodiment is shown in FIG. 1. The light convergence substrate 100 is made from a piece of concave aluminum plate having a rotary parabolic surface 101. The photonic crystal layer 300 is made of polymethyl methacrylate and SiO₂. Thickness of the photonic crystal layer 300 is about 1500 nm. The up-conversion material of the up-conversion layer 200 is made of CaS:Eu³⁺/Sm³⁺. Thickness of the up-conversion layer 200 is about 1 µm.

The light convergence device 10 is manufactured by the following process.
(1) Providing a piece of concave aluminum plate to serve as a substrate, and the substrate is cleaned and dried;
(2) A manufacturing method as disclosed in Chinese patent application NO. 200810018360.9 is used to prepare the photonic crystal layer. In this embodiment, polymethyl methacrylate of high polymer basic material is coated on substrate. Monodisperse latex particles SiO₂ having particle size of about 300 nm is mixed in the polymethyl methacrylate high polymer basic material by applying nano-imprint, thus the monodisperse latex particles mixed in the high polymer basic material form face-centered cubic structure. A photonic crystal layer having thickness of 10 µm is then formed when it is dried.
(3) Nano-particles (particle size of about 100nm) of CaS:Eu³⁺/Sm³⁺ weighted 2.5g is dispersed in 25g polymethyl methacrylate. The nano-particles are mixed uniformly and sprayed on the photonic crystal layer prepared by step (2). The nano-particles are then cured to form an up-conversion layer having thickness of 1µm in 12 hours and under 70 °C temperature environment. The up-conversion layer can be used to convert 800nm to 1600nm infrared light into visible light having wavelength of 625nm peak value. The photons in such wave band can be absorbed efficiently by organic solar batteries. As the solar light can be reflected and converged by the photonic crystal layer, thus efficiency and lifetime of the solar batteries can be greatly improved.

As disclosed in the above embodiments, in one aspect, the up-conversion layer can be used to convert infrared lights of different wavelengths into visible light with a special wavelength, and the visible light thus can be absorbed fully by organic solar batteries. Thus efficiency of the solar batteries can be greatly improved. In another aspect, the photonic crystal layer can be used to reflect light with special frequency, or to totally reflect visible light. In addition, the concave organic glass can be used to converge solar light. In this way, efficiency and lifetime of the solar batteries can be greatly improved. The layered structure is simple (without any other additional complex structure). In the manufacturing method as disclosed above, the light convergence device 10 can be made by preset steps to form each layer of the device, the processing step is simple and cost efficient, thus has broad application prospects.

Although the present disclosure has been specially described on the basis of the exemplary embodiment thereof, the disclosure is only limited by the scope of the claims.

## Claims

1. A light convergence device (10) comprising:
a light convergence substrate (100), the light convergence substrate (100) comprising a rotating paraboloid (101), wherein a photonic crystal layer (300) is formed on the rotating paraboloid (101), and an up-conversion layer (200) is formed on the photonic crystal layer (300), the up-conversion layer (200) comprises an up-conversion material with up- conversion function for spectrum; the photonic crystal layer (300) is provided on the inner surface of the rotating paraboloid (101) between the rotating paraboloid (101) and the up-conversion layer (200); and a photonic band gap of the photonic crystal layer (300) is at least in a range from 300nm to 800nm.

2. The light convergence device (10) of claim 1, wherein the up-conversion material is selected from a group consisting of halides, oxides, sulfides mixed with singly doped rare-earth ions or co-doped rare-earth ions, and combination thereof.

3. The light convergence device (10) of claim 1, wherein the up-conversion material is selected from a group consisting of BaY₂F₈, KZnF₃, NaYF₄, NaYb(WO₄)₂, Ga₂S₃-La₂O₃, CaS, Cs₃Lu₂Br₉, Y₂O₃, Gd₂O₃, ZrO₂, ZnO, BaTiO₃, ZrF₂-SiO₂, and ZnO-SiO₂ mixed with singly doped or co-doped rare-earth ions.

4. The light convergence device (10) of claim 2 or claim 3, wherein the singly doped or co-doped rare-earth ions are selected from a group consisting of Er³⁺, Ho³⁺, Tm³⁺, Pr³⁺, Yb³⁺/Ho³⁺, Yb³⁺/Tm³⁺, Yb³⁺/Pr³⁺, Yb³⁺/Er³⁺, and Tb³⁺/Er³⁺.

5. The light convergence device (10) of claim 1, wherein the up-conversion layer (200) is a layer consisting of organic material and up-conversion material dispersed in the organic material, or a composite structure using oxidation film encapsulating the up-conversion material; and the photonic crystal layer (300) and the up-conversion layer (200) each are concave along the rotating paraboloid (101).

6. The light convergence device (10) of claim 1, wherein thickness of the photonic crystal layer (300) is 100nm to 2000nm, and thickness of the up-conversion layer (200) is 0.1 µm to 20µm.

7. A manufacturing method of a light convergence device (10), comprising: providing a light convergence substrate (100), the light convergence substrate (100) comprising a rotating paraboloid (101);
forming a photonic crystal layer (300) on the rotating paraboloid (101);
forming an up-conversion layer (200) on the photonic crystal layer (300), wherein the up- conversion layer (200) comprises an up-conversion material with up-conversion function for spectrum; wherein the photonic crystal layer (300) is provided on the inner surface of the rotating paraboloid (101) between the rotating paraboloid (101) and the up-conversion layer (200), and a photonic band gap of the photonic crystal layer (300) is at least in a range from 300nm to 800nm.

8. The manufacturing method of a light convergence device (10) of claim 7, wherein the up-conversion material is selected from a group consisting of halides, oxides, sulfides mixed with singly doped rare-earth ions or co-doped rare-earth ions, and combination thereof, and the singly doped or co-doped rare-earth ions are selected from a group consisting of Er³⁺, Ho³⁺, Tm³⁺, Pr³⁺, Yb³⁺/Ho³⁺, Yb³⁺/Tm³⁺, Yb³⁺/Pr³⁺, Yb³⁺/Er²⁺, and Tb³⁺/Er³⁺.

9. The manufacturing method of a light convergence device (10) of claim 7, wherein the up-conversion material is formed by firstly applying a sol - gel method to produce a plurality of up-conversion material particles mixed in organic material, and then by coating the mixed organic material on the photonic crystal layer (300); or the up-conversion material is formed by firstly applying a chemical homogeneous coprecipitation method to encapsulate the up-conversion material with an oxidation film, and then by coating the oxidation film on the photonic crystal layer (300).

10. A solar battery system comprising:
a light convergence device (10) any of claim 1 to claim 6; and
a solar battery device arranged at an imaginary light convergence flat plane where light is converged by the rotating paraboloid (101) of the light convergence device (10).

## Patentansprüche

1. Lichtkonvergenzvorrichtung (10), umfassend:
ein Lichtkonvergenzsubstrat (100), wobei das Lichtkonvergenzsubstrat (100) ein Rotationsparaboloid (101) umfasst, in dem eine photonische Kristallschicht (300) auf dem Rotationsparaboloid (101) ausgebildet ist, und eine Hochkonversionsschicht (200) auf der photonischen Kristallschicht (300) ausgebildet ist, wobei die Hochkonversionsschicht (200) ein Hochkonversionsmaterial mit Hochkonversionsfunktion für ein Spektrum umfasst, wobei die photonische Kristallschicht (300) auf der Innenfläche des Rotationsparaboloids (101) zwischen dem Rotationsparaboloid (101) und der Hochkonversionsschicht (200) vorgesehen ist; und wobei eine photonische Bandlücke der photonischen Kristallschicht (300) zumindest in einem Bereich von 300 nm bis 800 nm ist.

2. Lichtkonvergenzvorrichtung (10) nach Anspruch 1, wobei das Hochkonversionsmaterial aus einer Gruppe, die aus Halogeniden, Oxiden, Sulfiden, die mit einfach dotierten Seltenerdionen oder ko-dotierten Seltenerdionen gemischt sind, und Kombinationen derselben besteht, ausgewählt ist.

3. Lichtkonvergenzvorrichtung (10) nach Anspruch 1, wobei das Hochkonversionsmaterial aus einer Gruppe, die aus BaY₂F₈, KZnF₃, NaYF₄, NaYb(WO₄)₂, Ga₂S₃-La₂O₃, CaS, Cs₃Lu₂Br₉, Y₂O₃, Gd₂O₃, ZrO₂, ZnO, BaTiO₃, ZrF₂-SiO₂ und ZnO-SiO₂, die mit einfach dotierten oder ko-dotierten Seltenerdionien gemischt sind, besteht, ausgewählt ist.

4. Lichtkonvergenzvorrichtung (10) nach Anspruch 2 oder Anspruch 3, wobei die einfach dotierten oder ko-dotierten Seltenerdionen aus einer Gruppe, die aus Er³⁺, Ho³⁺, Tm³⁺, Pr³⁺, Yb³⁺/Ho³⁺, Yb³⁺/Tm³⁺, Yb³⁺/Pr³⁺, Yb³⁺/Er³⁺ und Tb³⁺/Er³⁺ besteht, ausgewählt sind.

5. Lichtkonvergenzvorrichtung (10) nach Anspruch 1, wobei die Hochkonversionsschicht (200) eine Schicht ist, die aus organischem Material und Hochkonversionsmaterial, das in dem organischen Material dispergiert ist, oder einer zusammengesetzten Struktur, die einen das Hochkonversionsmaterial einkapselnden Oxidationsfilm anwendet, besteht; und wobei die photonische Kristallschicht (300) und die Hochkonversionsschicht (200) jeweils entlang des Rotationsparaboloids (101) konkav sind.

6. Lichtkonvergenzvorrichtung (10) nach Anspruch 1, wobei die Dicke der photonischen Kristallschicht (300) 100 nm bis 2000 nm ist, und die Dicke der Hochkonversionsschicht (200) 0,1 µm bis 20 µm ist.

7. Herstellungsverfahren einer Lichtkonvergenzvorrichtung (10), umfassend:
Bereitstellen eines Lichtkonvergenzsubstrats (100), wobei das Lichtkonvergenzsubstrat (100) ein Roationsparaboloid (101) umfasst;
Ausbilden einer photonischen Kristallschicht (300) auf dem Rotationsparaboloid (101);
Ausbilden einer Hochkonversionsschicht (200) auf der photonischen Kristallschicht (300), wobei die Hochkonversionsschicht (200) ein Hochkonversionsmaterial mit Hochkonversionsfunktion für ein Spektrum umfasst, wobei die photonische Kristallschicht (300) auf der Innenoberfläche des Rotationsparaboloids (101) zwischen dem Rotationsparaboloid (101) und der Hochkonversionsschicht (200) vorgesehen ist, und eine photonische Bandlücke der photonischen Kristallschicht (300) zumindest im Bereich von 300 nm bis 800 nm ist.

8. Herstellungsverfahren einer Lichtkonvergenzvorrichtung (10) nach Anspruch 7, wobei das Hochkonversionsmaterial aus der Gruppe, die aus Halogeniden, Oxiden, Sulfiden, die mit einfach dotierten Seltenerdionen oder ko-dotierten Seltenerdionen gemischt sind, und Kombinationen derselben besteht, ausgewählt ist, und die einfach dotierten oder ko-dotierten Seltenerdionen aus einer Gruppe, die aus Er³⁺, Ho³⁺, Tm³⁺, Pr³⁺, Yb³⁺/Ho³⁺, Yb³⁺/Tm³⁺, Yb³⁺/Pr³⁺, Yb³⁺/Er³⁺ und Tb³⁺/Er³⁺ besteht, ausgewählt sind.

9. Herstellungsverfahren einer Lichtkonvergenzvorrichtung (10) nach Anspruch 7,
wobei das Hochkonversionsmaterial ausgebildet wird, indem zuerst ein Sol-Gel-Verfahren zur Anwendung kommt, um eine Vielzahl von in organisches Material gemischten Hochkonversionsmaterialpartikeln zu erzeugen, und anschließend das gemischte organische Material auf der photonischen Kristallschicht (300) beschichtet wird; oder
wobei das Hochkonversionsmaterial ausgebildet wird, indem zuerst ein chemisches homogenes Mitfällungsverfahren zur Anwendung kommt, um das Hochkonversionsmaterial mit einem Oxidationsfilm einzukapseln, und anschließend der Oxidationsfilm auf der photonischen Kristallschicht (300) beschichtet wird.

10. Solarbatteriesystem, umfassend:
eine Lichtkonvergenzvorrichtung (10) nach einem der Ansprüche 1 bis 6; und
eine Solarbatterievorrichtung, die auf einer imaginären flachen Lichtkonvergenz-Ebene angeordnet ist, wobei Licht durch das Rotationsparaboloid (101) der Lichtkonvergenzvorrichtung (10) konvergiert wird.

## Revendications

1. Dispositif de convergence de lumière (10) comprenant : un substrat de convergence de lumière (100), le substrat de convergence de lumière (100) comprenant un paraboloïde de révolution (101), dans lequel une couche de cristaux photoniques (300) est formée sur le paraboloïde de révolution (101), et une couche de conversion ascendante (200) est formée sur la couche de cristaux photoniques (300), la couche de conversion ascendante (200) comprend un matériau de conversion ascendante ayant une fonction de conversion ascendante pour le spectre ; la couche de cristaux photoniques (300) est disposée sur la surface interne du paraboloïde de révolution (101) entre le paraboloïde de révolution (101) et la couche de conversion ascendante (200) ; et une bande interdite photonique de la couche de cristaux photoniques (300) est au moins dans une plage de 300 nm à 800 nm.

2. Dispositif de convergence de lumière (10) selon la revendication 1, dans lequel le matériau de conversion ascendante est choisi dans un groupe constitué d'halogénures, oxydes, sulfures mélangés avec des ions de terre rare dopés de façon unique ou des ions de terre rare codopés, et une combinaison de ceux-ci.

3. Dispositif de convergence de lumière (10) selon la revendication 1, dans lequel le matériau de conversion ascendante est choisi dans un groupe constitué de BaY₂F₈, KZnF₃, NaYF₄, NaYb(WO₄)₂, Ga₂S₃-La₂O₃, CaS, Cs₃Lu₂Br₉, Y₂O₃, Gd₂O₃, ZrO₂, ZnO, BaTiO₂, ZrF₂-SiO₂, et ZnO-SiO₂ mélangé avec des ions de terre rare dopés de façon unique ou codopés.

4. Dispositif de convergence de lumière (10) selon la revendication 2 ou la revendication 3, dans lequel les ions de terre rare dopés de façon unique ou codopés sont choisis dans un groupe constitué de Er³⁺, Ho³⁺, Tm³⁺, Pr³⁺, Yb³⁺/Ho³⁺, Yb³⁺/Tm³⁺, Yb³⁺/Pr³⁺, Yb³⁺/Er³⁺ et Tb³⁺/Er³⁺.

5. Dispositif de convergence de lumière (10) selon la revendication 1, dans lequel la couche de conversion ascendante (200) est une couche constituée de matériau organique et de matériau de conversion ascendante dispersés dans le matériau organique, ou une structure composite utilisant un film d'oxydation encapsulant le matériau de conversion ascendante ; et la couche de cristaux photoniques (300) et la couche de conversion ascendante (200) sont chacune concaves le long du paraboloïde de révolution (101).

6. Dispositif de convergence de lumière (10) selon la revendication 1, dans lequel l'épaisseur de la couche de cristaux photoniques (300) est de 100 nm à 2000 nm, et l'épaisseur de la couche de conversion ascendante (200) est de 0,1 µm à 20 µm.

7. Procédé de fabrication d'un dispositif de convergence de lumière (10), comprenant : la fourniture d'un substrat de convergence de lumière (100), le substrat de convergence de lumière (100) comprenant un paraboloïde de révolution (101) ; la formation d'une couche de cristaux photoniques (300) sur le paraboloïde de révolution (101) ; la formation d'une couche de conversion ascendante (200) sur la couche de cristaux photoniques (300), dans lequel la couche de conversion ascendante (200) comprend un matériau de conversion ascendante ayant une fonction de conversion ascendante pour le spectre ; dans lequel la couche de cristaux photoniques (300) est disposée sur la surface interne du paraboloïde de révolution (101) entre le paraboloïde de révolution (101) et la couche de conversion ascendante (200), et une bande interdite photonique de la couche de cristaux photoniques (300) est au moins dans une plage de 300 nm à 800 nm.

8. Procédé de fabrication d'un dispositif de convergence de lumière (10) selon la revendication 7, dans lequel le matériau de conversion ascendante est choisi dans un groupe constitué d'halogénures, d'oxydes, de sulfures mélangés avec des ions de terre rare dopés de façon unique ou codopés, et une combinaison de ceux-ci, et les ions de terre rare dopés ou codopés sont choisis dans un groupe constitué de Er³⁺, Ho³⁺, Tm³⁺, Pr³⁺, Yb³⁺/Ho³⁺, Yb³⁺/Tm³⁺, Yb³⁺/Pr³⁺, Yb³⁺/Er³⁺ et Tb³⁺/Er³⁺.

9. Procédé de fabrication d'un dispositif de convergence de lumière (10) selon la revendication 7, dans lequel le matériau de conversion ascendante est formé dans un premier temps par application d'un procédé sol-gel pour produire une pluralité de particules de matériau de conversion ascendante mélangées dans un matériau organique, et ensuite par enduction du matériau organique mélangé sur la couche de cristaux photoniques (300) ; ou bien le matériau de conversion ascendante est formé dans un premier temps par application d'un procédé de coprécipitation homogène chimique pour encapsuler le matériau de conversion ascendante avec un film d'oxydation, et ensuite par enduction du film d'oxydation sur la couche de cristaux photoniques (300).

10. Système de batterie solaire comprenant :
un dispositif de convergence de lumière (10) selon l'une quelconque de la revendication 1 à la revendication 6 ; et
un dispositif de batterie solaire agencée au niveau d'un plan plat de convergence de lumière imaginaire où la lumière est amenée à converger par le paraboloïde de révolution (101) du dispositif de convergence de lumière (10) .
